## Europäisches Patentamt
## European Patent Office
## Office européen des brevets

(11) Veröffentlichungsnummer: **0 043 863 B1**

(12) **EUROPÄISCHE PATENTSCHRIFT**

(45) Veröffentlichungstag der Patentschrift:
**16.05.84**

(21) Anmeldenummer: **80103966.0**

(22) Anmeldetag: **10.07.80**

(51) Int. Cl.³: **G 03 F 7/20**

(54) Verfahren zur Kompensation des Proximity Effekts bei Elektronenstrahl-Projektionsanlagen.

(43) Veröffentlichungstag der Anmeldung:
**20.01.82 Patentblatt 82/3**

(45) Bekanntmachung des Hinweises auf die Patenterteilung:
**16.05.84 Patentblatt 84/20**

(84) Benannte Vertragsstaaten:
**DE FR GB**

(56) Entgegenhaltungen:
**EP - A - 0 001 042**
**US - A - 4 198 569**

**EXTENDED ABSTRACTS, Band 80-1, Mai 1980, Zusammenfassung 260, Seiten 663-665 PRINCETON (US) N. SUGIYAMA et al.: "Advanced EB Proximity Effect Correction for Fine-Pattern Device Fabrication"**

(73) Patentinhaber: **International Business Machines Corporation, Old Orchard Road, Armonk, N.Y. 10504 (US)**
(84) Benannte Vertragsstaaten: **FR GB**

(73) Patentinhaber: **IBM DEUTSCHLAND GMBH, Pascalstrasse 100, D-7000 Stuttgart 80 (DE)**
(84) Benannte Vertragsstaaten: **DE**

(72) Erfinder: **Bohlen, Harald, Geleener Strasse 26, D-7030 Böblingen (DE)**
Erfinder: **Engelke, Helmut, Dr., Ahornweg 33, D-7031 Altdorf (DE)**
Erfinder: **Greschner, Johann, Dr., Zollernstrasse 14, D-7401 Pliezhausen (DE)**
Erfinder: **Nehmiz, Peter, Dr., Karl-Weller-Strasse 2, D-7000 Stuttgart 80 (DE)**

(74) Vertreter: **Teufel, Fritz, Dipl.-Phys., Schönalcher Strasse 220, D-7030 Böblingen (DE)**

## Verfahren zur Kompensation des Proximity Effekts
## bei Elektronenstrahl-Projektionsanlagen

Die Erfindung betrifft ein Verfahren zur Kompensation des Proximity Effekts nach dem Oberbegriff des Hauptanspruchs.

Bei der Herstellung integrierter Schaltkreise werden zur Reduzierung der Herstellkosten und zur Erhöhung der Arbeitsgeschwindigkeit immer kleinere Strukturen gefordert. Leiterzüge, deren Breite im Bereich von 1 μm und darunter liegt, können mit den heute gebräuchlichen photolithographischen Verfahren nicht mehr aufgelöst werden.

Lithographieverfahren mit Elektronenstrahlen ermöglichen zwar im Prinzip eine sehr viel höhere Auflösung bei der Übertragung von Mustern, doch bestehen in der Praxis erhebliche Schwierigkeiten aufgrund von Streueffekten der Elektronen in der zu belichtenden Photolackschicht und im Substrat. Dieser unerwünschte Effekt wird als Proximity Effekt bezeichnet.

Bei den üblicherweise verwendeten Elektronenstrahlenergien von 25 keV beträgt die Reichweite der Elektronen im Photolack und im Substrat etwa 5 μm, bevor sie durch Stöße mit Atomen und Elektronen abgebremst werden. Dies führt zu einer lateralen Streuung der auftreffenden Elektronen um etwa diesen Betrag und damit zu einer beträchtlichen Verschmierung der übertragenen Muster.

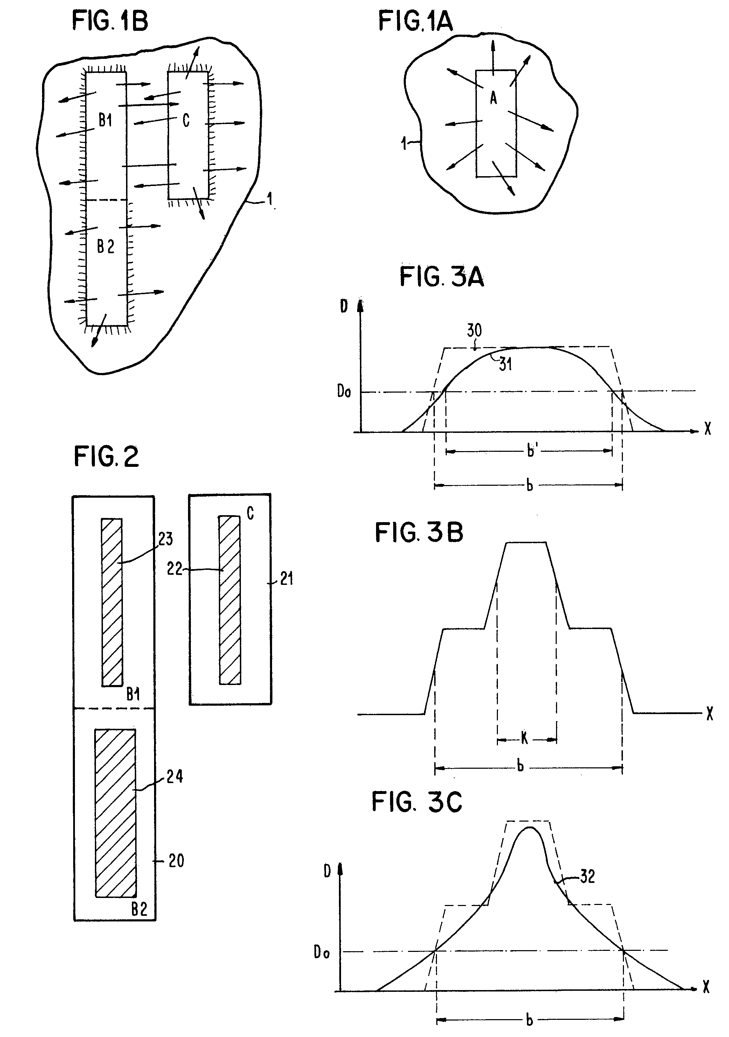

Die Auswirkungen dieser Streuung sind in Fig. 1 veranschaulicht. Fig. 1A zeigt ein isoliertes Musterelement A in einer Photolackschicht 1; dieses Musterelement kann beispielsweise durch rasterförmige Beleuchtung mit einem feinen Elektronenstrahl erzeugt werden oder aber durch Projektion einer entsprechenden Maskenöffnung mit einem Elektronenstrahlbündel größeren Durchmessers. Die im Bereich A auftreffenden Elektronen werden teilweise dort absorbiert, ein Teil (durch Pfeile dargestellt) gelangt jedoch außerhalb des Bereichs A und geht somit für die Belichtung des Photolacks im Bereich A verloren. Zur Kompensation dieser Streuverluste muß deshalb der Bereich A mit einer höheren Bestrahlungsdosis beaufschlagt werden.

Die Bemessung der höheren Bestrahlungsdosis hängt jedoch von der unmittelbaren Umgebung des jeweils betrachteten Musterelements ab. Liegen zwei Musterelemente nahe beieinander, z. B. die Bereiche B1 und C in Fig. 1B, so gibt jedes Element Streuelektronen an das Nachbarelement ab, empfängt aber auch von dort Streuelektronen. Insgesamt ist in jedem der Elemente B1 und C die empfangene Dosis also höher als in einem isoliert liegenden Element B2.

Zur Korrektur des Proximity Effekts wurde deshalb schon vorgeschlagen, die einzelnen Teilbereiche eines Musters verschieden stark mit Elektronenstrahlen zu beaufschlagen und die jeweilige Dosis so zu bestimmen, daß Streuelektronen benachbarter Musterelemente berücksichtigt werden. Ein entsprechendes Verfahren ist in dem Artikel von Mihir Parikh »Self-consistent proximity effect correction technique for resist exposure« in J. Vac. Sci. Techn. Vol. 15, No. 3, May/June 1978 beschrieben. Die Ermittlung der jeweiligen Bestrahlungsdosis erfordert jedoch einen großen Rechenaufwand (in einem Computer); eine lokale Änderung der Bestrahlungsdosis kann außerdem nur in einem Elektronenstrahl-Belichtungssystem erfolgen, bei dem der Elekronenstrahl als feiner Griffel über die jeweils zu belichtende Fläche geführt wird (Rasteroder Vector-Scan-Prinzip).

Elektronenstrahl-Belichtungssysteme mit rasterförmiger Strahlablenkung führen jedoch zu großen Belichtungszeiten und sind daher für eine wirtschaftliche Halbleiterherstellung nur bedingt geeignet. Elektronenstrahl-Projektionssysteme, bei denen eine Belichtungsmaske durch einen aufgeweiteten Elektronenstrahl nach dem Schattenwurfverfahren abgebildet wird, weisen diesen Nachteil nicht auf. Bei derartigen Systemen kann jedoch keine lokale Veränderung der Belichtungsdosis und somit keine Kompensation des Proximity Effekts erfolgen; der praktische Einsatz von Elektronenstrahl-Projektionssystemen zur Herstellung hochintegrierter Schaltkreise ist deshalb in Frage gestellt. Es wurde daher schon der Vorschlag gemacht, überhaupt auf eine Elektronenstrahl-Projektionsbelichtung zu verzichten und stattdessen Ionenstrahlen zu verwenden, bei denen aufgrund der höheren Ionenmasse Streueffekte nur eine sehr untergeordnete Rolle spielen. Derartige Ionensysteme benötigen aber zur Strahlerzeugung und Strahlsteuerung einen sehr viel höheren Aufwand.

Ein weiterer Weg zur Kompensation des Proximity Effekts, der im Prinzip auch für Elektronenstrahl-Projektionssysteme gangbar wäre, besteht darin, die einzelnen Musterelemente nicht in ihren Nominalabmessungen zu belichten, sondern das Belichtungsgebiet größer als das gewünschte Musterelement zu wählen. Bei der Entwicklung des Photolacks ergibt sich dann als Folge des Proximity Effekts eine Schrumpfung auf die gewünschten Nominaldimensionen.

Die genaue Bemessung des zu belichtenden Gebiets, unter Berücksichtigung der späteren Schrumpfung, wird jedoch bei komplizierteren Mustern außerordentlich kompliziert und kann insbesondere nicht mehr mit automatischen Berechnungsverfahren erfolgen. Damit scheidet diese Methode aber als praktisches Hilfsmittel für die Produktion aus; eine Korrektur des Proximity Effekts kann unter diesen Umständen nur durch eine Variation der Bestrahlungsdosis erfolgen.

Die vorliegende Erfindung stellt sich daher die Aufgabe, ein schnell durchführbares Verfahren zur Kompensation des Proximity Effekts anzugeben, das bei Elektronenstrahl-Projektionsanlagen verwendbar ist; dazu soll außerdem ein Meßverfahren für den Proximity Effekt angegeben werden, das einfach zu handhaben ist.

Diese Aufgabe wird durch die in den Ansprüchen 1 und 7 gekennzeichnete Erfindung gelöst; Ausgestaltungen der Erfindung sind in den Unteransprüchen gekennzeichnet.

Zur Kompensation des Proximity Effekts schlägt die Erfindung vor, den einzelnen Elementen eines Musters die unter Berücksichtigung des Proximity Effekts erforderliche, jeweilige lokale Bestrahlungsdosis in zwei oder mehreren Belichtungsschritten mit jeweils gleicher Dosis, jedoch verschiedenen Masken zuzuführen. Diese Mehrfachbelichtung ausgewählter Musterelemente läßt sich bei Verwendung von sogenannten Komplementärmasken ohne weiteres dadurch erreichen, daß zusätzliche Maskenöffnungen für Mustergebiete der einen Maske jeweils in der zugehörigen Komplementärmaske angebracht werden.

Mit dem hier vorgeschlagenen Verfahren und unter Verwendung entsprechend modifizierter Komplementärmasken kann die Auflösung der Elektronenstrahlprojektion bis zu Strukturen von 0,5 µm verbessert werden. Der dazu erforderliche Aufwand beschränkt sich auf die einmalige Bestimmung von Gestalt und Anordnung der zusätzlichen Öffnungen in den Komplementärmasken.

Zur genauen Untersuchung der Auswirkungen des Proximity Effekts und zur Bemessung der Zusatzöffnungen wird außerdem eine entsprechend empfindliche und trotzdem einfach zu handhabende Meßmethode angegeben. Dazu wird vorgeschlagen, den Photolack mit bestimmten, feinen Strukturen zu belichten und den Entwicklungsvorgang vorzeitig abzubrechen, um Angaben über Unterätzungen aufgrund des Proximity Effekts zu erhalten.

Ausführungsbeispiele der Erfindung werden nun anhand von Zeichnungen näher erläutert. Es zeigt

Fig. 1 eine schematische Darstellung der Auswirkung des Proximity Effekts,

Fig. 2 eine Prinzipdarstellung zur Kompensation des Proximity Effekts durch Mehrfachbelichtung von Musterelementen,

Fig. 3 in den Teilfiguren A bis C Querschnitte durch dünne Photolackstrukturen bzw. Profile der Bestrahlungsdosis zur Erläuterung des Proximity Effekts und seiner Kompensation,

Fig. 4 in Teilfigur A ein Musterelement mit isolierter Insel und in den Teilfiguren B, C komplementäre Belichtungsmasken zur Herstellung eines Musterelements mit Inselstruktur,

Fig. 5 in Teilfigur A ein Musterelement mit Inselstruktur und Angabe der zur Kompensation des Proximity Effekts doppelt zu belichtenden Teilmuster,

Fig. 5B, C Lage der Gebiete doppelter Belichtung in den komplementären Belichtungsmasken nach Fig. 4B, C,

Fig. 5D, E komplementäre Belichtungsmasken nach Fig. 4B, C mit zusätzlichen Maskenöffnungen, die jeweils den doppelt zu belichtenden Abschnitten der anderen Komplementärmaske entsprechen,

Fig. 6 in den Teilfiguren A, C den Querschnitt durch ein Photolackprofil nach 100%iger bzw. 70%iger Entwicklungszeit, wenn kein Proximity Effekt auftritt; in den Teilfiguren B, D den Querschnitt durch ein Photolackprofil nach 100%iger bzw. 70%iger Entwicklungszeit, wenn ein Proximity Effekt auftritt,

Fig. 7 in den Teilfiguren A bis D lichtoptische Bilder eines Prüfmusters aus Linien mit zunehmender Linienbreite, aufgenommen zu verschiedenen Zeitpunkten des Entwicklungsprozesses.

Das allgemeine Verfahren zur Kompensation des Proximity Effekts bei Elektronenstrahl-Projektionsanlagen besteht darin, ein komplexes Belichtungsmuster in einzelne Teilmuster zu unterteilen und für jedes Teilmuster die zur Kompensation des Proximity Effekts erforderliche, zusätzliche Belichtung (Elektronenstrahldosis) zu bestimmen. Diese zusätzliche Bestrahlungsdosis hängt von der jeweiligen Umgebung jedes Teilmusters ab. Abhängig von der ermittelten Bestrahlungsdosis und der Form des Teilmusters wird eine Öffnung in einer Belichtungsmaske definiert, mit der das Teilmuster ein zweites Mal belichtet wird, und zwar mit einem Elektronenstrahl derselben Intensität wie bei der ersten Belichtung.

Fig. 2 zeigt dieses Verfahren am Beispiel eines Belichtungsmusters, wie es anhand von Fig. 1 beschrieben wurde. Das längliche Teilmuster 20 wird in zwei Bereiche B1, B2 aufgespalten, wobei B1 dem Teilmuster C mit Bezugszeichen 21 gegenüberliegt. Die Teilmuster B1 und C empfangen jeweils Streuelektronen des anderen Teilmusters und benötigen daher zur Kompensation des Proximity Effekts nur eine relativ kleine zusätzliche Bestrahlungsdosis; diese zusätzliche Dosis wird durch eine zweite Belichtung in den schraffiert dargestellten Bereichen 22, 23 zugeführt. Das isoliert liegende Teilmuster B2 erhält keine (oder weniger) Streuelektronen anderer Teilmuster, so daß die insgesamt zu seiner Belichtung verfügbare Bestrahlungsdosis deutlich geringer ist als bei den Teilmustern B1 und C. Die zusätzliche Belichtung zur Kompensation des Proximity Effekts muß deshalb mit stärkerer Dosis erfolgen; entsprechend ist das in der zweiten Belichtung beaufschlagte (schraffiert dargestellte) Gebiet 24 größer als in den Teilmustern B1 und C. Die genaue Größe und die genaue Lage der schraffiert dargestellten Gebiete zweiter Belichtung muß für jeden Einzelfall unter Berücksichtigung aller Verluste und Beiträge des Proximity Effekts für jedes Teilmuster genau bestimmt werden. Dies kann rechnerisch (mit Algorithmen oder mit Tabellen für Standardmuster) erfolgen oder experimentell durch Messung der jeweils erforderlichen Zusatzdosis. Ein Meßverfahren für den Proximity Effekt wird später im einzelnen erläutert.

Die Auswirkungen des Proximity Effekts und der zusätzlichen Korrekturbelichtung auf ein stegförmiges Profil im Photolack sind in Fig. 3 dargestellt. In Fig. 3A ist über eine Ortskoordinate (X) die Bestrahlungsdosis (D) aufgetragen; der gestrichelt dargestellte Linienzug 30 stellt die Verteilung der Bestrahlungsdosis dar, wenn im Photolack keine Streuung der Elektronen auftritt, die durchgezogene Linie 31 stellt den Fall mit Elektronenstreuung dar. Die Mindestdosis, die zur Belichtung des Photolacks erforderlich ist, habe den Wert $D_0$; die Linienbreite im entwickelten Photolack ergibt sich dann aus dem Schnittpunkt der Dosisverteilung mit der Mindestdosis $D_0$. Aus Fig. 3A ist ersichtlich, daß die Breite b im Fall ohne Streuung (die der gewünschten Nominalbreite entspricht) nicht erreicht wird, wenn Streueffekte auftreten, sondern nur eine reduzierte Breite b'.

Zur Kompensation dieses Proximity Effekts schlägt die Erfindung vor, anstelle einer Verteilung der Bestrahlungsdosis gemäß Linienzug 30 ein Intensitätsprofil gemäß Fig. 3B anzuwenden: Innerhalb der gewünschten Linienbreite b wird in einem Bereich k eine zusätzliche Belichtung (Elektronenbestrahlung) aufgebracht, beispielsweise mit einer zweiten Belichtungsmaske, deren Öffnung die Breite k aufweist. (Der trapezförmige Verlauf der Dosiskurve statt der theoretisch zu erwartenden senkrechten Begrenzungen ist durch unvermeidliche elektronenoptische Effekte bedingt.)

Das resultierende Belichtungsprofil der beiden überlagerten Belichtungen ist in Fig. 3C bei Bezugszeichen 32 dargestellt. Diese Kurve schneidet die waagerechte Gerade der Mindestbelichtung $D_0$ an den gewünschten Schnittpunkten, so daß sich nach der Belichtung des Photolacks die Nominalbreite b ergibt.

Die Doppelbelichtung zur Korrektur des Proximity Effekts kann beispielsweise in einem zweiten Belichtungsschritt erfolgen, dessen Belichtungsmaske Öffnungen enthält, die den doppelt zu belichtenden Mustern entsprechen.

Ein derartiger zweiter, nur zur Proximity-Effekt-Korrektur dienender Belichtungsschritt wird bei Verwendung von Komplementärmasken vermieden, wie sie in der EP-A-0 001 042 beschrieben sind. Aufgrund der starken Wechselwirkung von Elektronen mit Materie können bei Elektronenstrahl-Projektionsanlagen die Maskenmuster nicht auf einem »durchsichtigen« Substrat angebracht werden; stattdessen stellen die Maskenöffnungen vorzugsweise echte Löcher in der Maske dar. Damit lassen sich aber isolierte Musterelemente nicht darstellen, da diese keine Stütze haben. Durch Überlagerung zweier Komplementärmasken läßt sich dieses Problem jedoch lösen, indem die isolierte Struktur in geeignet geformte und unterstützte Teilstrukturen aufgelöst wird.

Die oben besprochene Korrektur des Proximity Effekts läßt sich nun bei Komplementärmasken ohne zusätzlichen Belichtungsschritt, sozusagen nebenbei, erreichen. Nach der Aufteilung des Maskenmusters in zwei Komplementärmasken wird für jedes der so entstandenen Teilmuster die erforderliche zusätzliche Korrekturbelichtung ermittelt und eine entsprechende Öffnung auf der jeweils anderen Komplementärmaske angebracht.

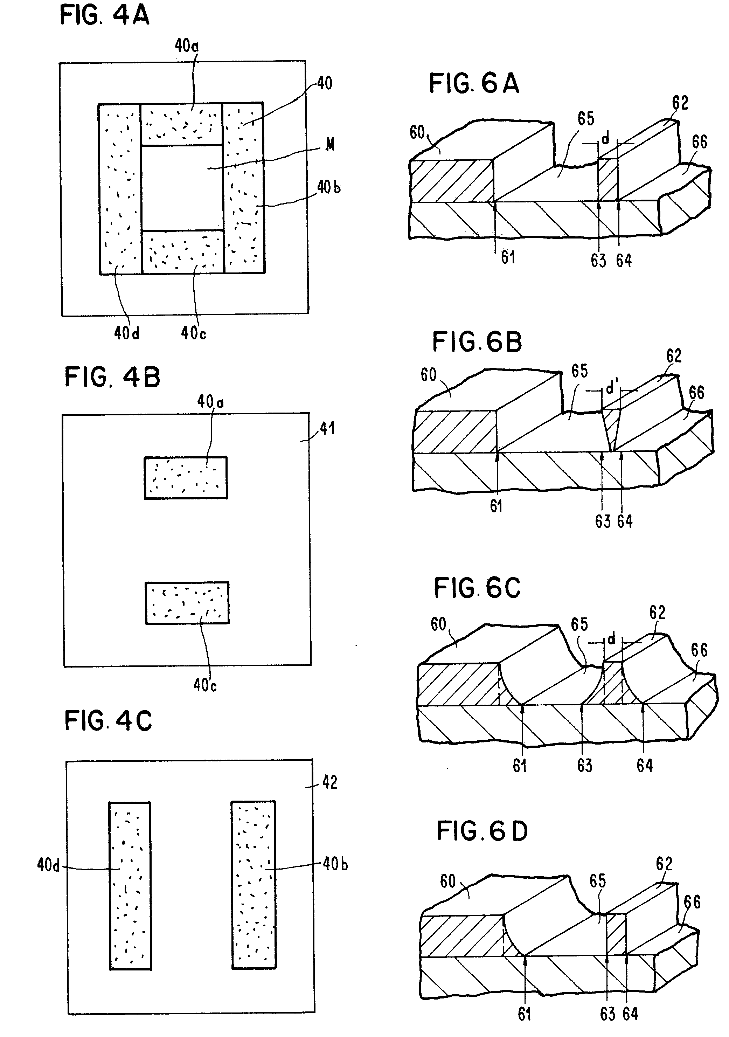

Das Prinzip der Komplementärmasken ist in Fig. 4 schematisch dargestellt: Der punktierte Ring 40 soll belichtet werden, das Mittelstück M dagegen nicht. Zur Bildung von Komplementärmasken 41 und 42 wird der Ring 40 in vier Teilbereiche 40a bis 40d zerlegt und jeweils zwei dieser Teilbereiche (40a und 40c bzw. 40b und 40d) auf einer Belichtungsmaske (41 bzw. 42) angeordnet. Durch aufeinanderfolgende Belichtung durch die beiden Masken 41, 42 ergibt sich wiederum der ringförmige Belichtungsbereich 40, ohne daß mechanische Stabilitätsprobleme für den Mittelbereich M aufgetreten wären.

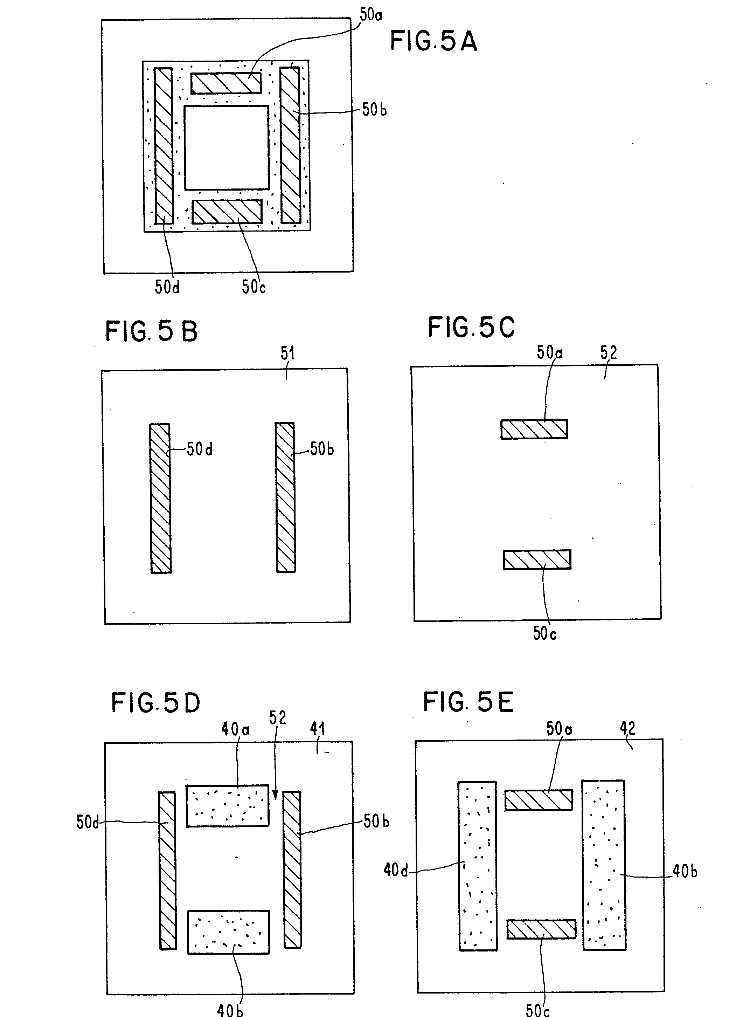

Zur Korrektur des Proximity Effekts in dem ringförmigen Belichtungsbereich von Fig. 4A sind Doppelbelichtungen in Gebieten notwendig, die in Fig. 5A schraffiert dargestellt und mit den Bezugszeichen 50a bis 50d versehen sind.

In Fig. 5B und 5C sind Korrekturmasken dargestellt, die verwendet werden könnten, wenn für jede Komplementärmaske ein zusätzlicher Belichtungsschritt zur Korrektur des Proximity Effekts durchgeführt werden würde. Die mit Bezugszeichen 51 versehene Korrekturmaske in Fig. 5B mit den Durchlaßbereichen 50b, 50d dient zur Korrektur der Komplementärmaske 42 mit den Bereichen 40b, 40d. Entsprechend die Korrekturmaske 52 in Fig. 5C mit den Durchlaßbereichen 50a, 50c zur Korrektur der Komplementärmaske 41 mit den Bereichen 40a, 40c. Diese zusätzlichen Korrekturmasken können jedoch entfallen, wenn die Korrekturmaske für eine Komplementärmaske in der jeweils anderen Komplementärmaske integriert wird.

Die Kombination von Komplementär- und Korrekturmasken sind in Fig. 5D und 5E dargestellt. Die Komplementärmaske 41 enthält somit die Korrekturöffnungen 50b, 50d für Komplementärmaske 42 und umgekehrt Komplementärmaske 42, die Korrekturöffnungen 50a, 50c für Komplementärmaske 41. Durch aufeinanderfolgende Belichtung durch die beiden einander ergänzenden Masken 41, 42 in Fig. 5D und E ergibt sich eine Belichtung gemäß Fig. 5A mit den gewünschten Bereichen doppelter Belichtung.

Um die mechanische Stabilität der Masken nach Fig. 5E und D zu gewährleisten, müssen die Korrekturöffnungen um einen geringen Betrag kleiner gemacht werden als die zugehörigen Belichtungsöffnungen. Dadurch bleiben in den Masken 41, 42 in Fig. 5D, E zwischen den eigentlichen Belichtungsöffnungen (z. B. 40a) und den Korrekturöffnungen (z. B. 50b) ausreichende Stege (z. B. 52) zur Trennung dieser Teilmuster übrig. Für die Stabilität der Masken genügen dabei Stegbreiten von 0,3 bis 0,4 μm.

Bei dem hier beschriebenen Verfahren der Kompensation des Proximity Effekts mit zwei Belichtungsstufen gleicher Belichtungsintensität kann einem Teilmuster als Korrekturdosis höchstens noch einmal die zur ursprünglichen Belichtung verwendete Dosis zugeführt werden (wenn nämlich die Öffnung der Korrekturmaske der Öffnung des Teilmusters entspricht). Diese Beschränkung der zuführbaren Korrekturbelichtung macht sich am stärksten bei isoliert liegenden Musterelementen (z. B. kleinen Quadraten) bemerkbar und beschränkt die Anwendbarkeit des Verfahrens auf Muster mit einer maximalen Auflösung von 0,5 µm. Bei noch geringeren Abmessungen der abzubildenden Strukturen sind die Verluste durch den Proximity Effekt größer als die maximal zuführbare Korrekturbestrahlung. Zur Kompensation in diesem Fall müßte die zusätzliche Belichtung mit höherer Intensität und/oder einer weiteren separaten Maske erfolgen.

Zur genauen Bestimmung von Lage und Form der doppelt zu belichtenden Musterteile muß die Reichweite des Proximity Effekts genau gemessen werden. Im folgenden wird ein Verfahren angegeben, mit dem eine direkte Messung dieser Reichweite erfolgen kann. Zu dieser Messung wird ein Testmuster auf den Photolack abgebildet und entwickelt, das aus mehreren Gruppen von Linienzügen gleicher Breite besteht, bei dem aber die Linienbreite von Gruppe zu Gruppe fein abgestuft (ungefähr $1/8$ µm) zunimmt.

Das Verhältnis der Linienbreite d zur Reichweite des Proximity Effekts im Photolack bestimmt das Aussehen der Kanten der Linien nach dem Entwickeln der Photolacks.

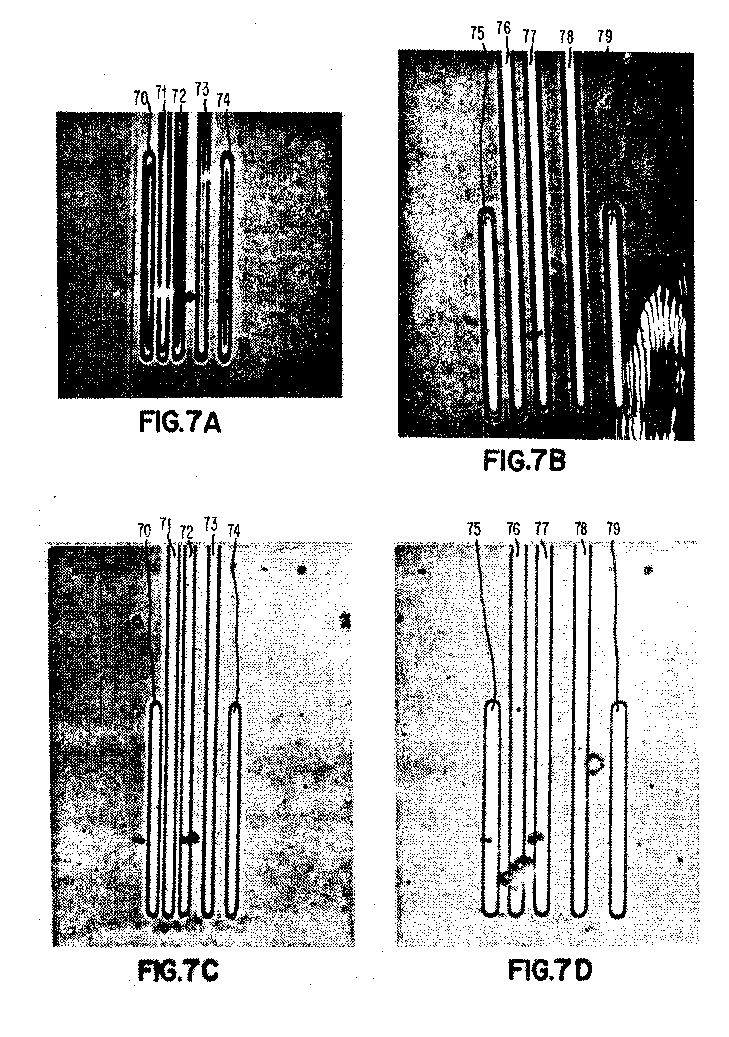

Fig. 6 zeigt schematisch den Einfluß des Proximity Effekts auf Kantenprofile. Als Prüfobjekt dient in Fig. 6 ein ausgedehnter Photolackbereich 60 mit einer Kante 61, sowie ein Steg 62 mit Kanten 63 und 64 und einer Breite d. Die Kante 61 erhält aufgrund des Proximity Effekts nur einseitig (vom belichteten Bereich 65) eine Rückstreudosis; die Dosis an der Kante 63 hängt dagegen davon ab, ob die Breite d des Steges größer ist oder kleiner als die Reichweite des Proximity Effekts. Im letzteren Fall, bei kleinerer Breite, erhält die Kante 63 Streuelektronen sowohl vom belichteten Bereich 65 als auch vom belichteten Bereich 66. Das Profil der Kante 63 wird sich also im Vergleich zum Profil von Kante 61 ändern, sobald die Dicke d einen Wert annimmt, der vergleichbar ist mit der Reichweite des Proximity Effekts.

In Fig. 6A sind die Verhältnisse nach vollständiger Entwicklung des Photolacks dargestellt, wenn die Breite d größer ist als der Proximity Effekt. Fig. 6B zeigt einen Steg mit einer Breite d' die kleiner als der Proximity Effekt; nach vollständiger Entwicklung des Photolacks ist aufgrund des Proximity Effekts an den Kanten 63 und 64 ein »Unterätzen« aufgetreten.

Die Unterscheidung der verschiedenen Kantenprofile kann prinzipiell lichtmikroskopisch oder mit einem Rasterelektronenmikroskop erfolgen (im letztgenannten Fall allerdings unter Zerstörung der Probe). Die Unterscheidung verschiedener Profile im Grenzbereich (d. h. Linienbreite d ≈ Reichweite des Proximity Effekts) ist jedoch sehr schwierig, da sich nur geringe Abweichungen bzw. eine geringe Unsymmetrie der Kanten 61 und 63, 64 ergibt.

Zur besseren Erkennbarkeit der Profile, insbesondere bei lichtmikroskopischer Betrachtung, wird deshalb vorgeschlagen, daß obenerwähnte belichtete Linienmuster nicht in der üblichen Weise vollständig zu entwickeln, sondern den Entwicklungsvorgang vorzeitig abzubrechen, beispielsweise nach ungefähr 70 bis 80% der gesamten Entwicklungszeit.

Anstelle des Profils in Fig. 6A ergibt sich dann ein Profil der in Fig. 6C gezeigten Art und anstelle des Profils in Fig. 6B das Profil nach Fig. 6D.

Die Unterscheidung der Profile zwischen den Fällen 6C und 6D läßt sich nun lichtmikroskopisch viel einfacher und deutlicher treffen als die Unterscheidung der Profile nach den Fig. 6A, B. Die Prüfung, ob das Kantenprofil 63 durch den Proximity Effekt verändert ist, kann leicht dadurch erfolgen, daß die Symmetrie der Profile 61 und 63 verglichen wird. Tritt bei abnehmender Stegbreite d zum ersten Mal eine Abweichung in der Symmetrie der beiden Kanten auf, so entspricht diese Stegbreite der Reichweite des Proximity Effekts. Da sich Unsymmetrien im Kantenprofil sehr leicht optisch feststellen lassen, steht mit diesem Verfahren der abgebrochenen Photolackentwicklung eine direkte und schnelle Messung der Reichweite des Proximity Effekts zur Verfügung.

In Fig. 7 sind die beiden Auswerteverfahren für Linientestmuster nebeneinandergestellt. Die miskroskopischen Aufnahmen A und B stammen von Prüfobjekten, bei denen der Entwicklungsvorgang nach 70% der Entwicklungszeit abgebrochen wurde. Die Teilfiguren C und D stellen dieselben Prüfmuster nach 100%iger Entwicklung dar. Die belichteten und freigeätzten Bereiche sind mit 70 bis 79 bezeichnet.

Fig. 7A betrifft den Fall, daß die Stegbreite d kleiner ist als die Reichweite des Proximity Effekts. Dementsprechend sind die linken und rechten Kanten des freigeätzten Bereichs 70 unsymmetrisch, mit der Folge, daß an der linken Kante des Bereichs 70 eine weitere dünne Linie erscheint. In Fig. 7B entspricht die Breite d gerade der Proximity Effekt Reichweite, so daß bei der schrittweisen Vergrößerung der Stegbreite d hier zum ersten Mal beide Kanten der Bereiche symmetrisch erscheinen.

Fig. 7C entspricht Fig. 7A nach 100%iger Entwicklung, Fig. 7D der Fig. 7B nach 100%iger Entwicklung. In beiden Fig. C und D ist es sehr schwer, wenn nicht unmöglich, Unterschiede aufgrund des Proximity Effekts festzustellen. Ein Unterätzen von Kanten macht sich nämlich optisch kaum bemerkbar.

**Patentansprüche**

1. Verfahren zur Kompensation des Proximity Effekts bei der Abbildung von Mustern in Elektronenstrahl-Projektionsanlagen, dadurch gekennzeichnet, daß für ausgewählte Bereiche des Musters mindestens zwei Elektronenstrahlbelichtungen durchgeführt werden, wobei der Querschnitt eines Belichtungsbündels gegenüber dem anderen in den Dimensionen reduziert ist.

2. Verfahren nach Anspruch 1, dadurch gekennzeichnet, daß die Elektronenstrahlbelichtungen mit gleicher Intensität durchgeführt werden.

3. Verfahren nach Anspruch 1 oder 2, dadurch gekennzeichnet, daß die einzelnen Bereiche entsprechend der für den Proximity Effekt maßgebenden, lokalen Umgebung ausgewählt werden.

4. Verfahren nach einem der Ansprüche 1 bis 3, dadurch gekennzeichnet, daß jede Belichtung eines ausgewählten Bereichs durch eine eigene Belichtungsmaske mit entsprechenden Öffnungen erfolgt.

5. Verfahren nach einem der Ansprüche 1 bis 3, dadurch gekennzeichnet, daß zur Belichtung eines bestimmten Musterelementes zwei komplementäre Einzelmasken (41, 42) verwendet werden, wobei jede Komplementärmaske zusätzliche Korrekturöffnungen (50b, d bzw. 50a, c) aufweist, um ausgewählte Bereiche der Belichtungszonen (40b, d bzw. 40a, c) der anderen Komplementärmaske doppelt zu belichten.

6. Verfahren nach Anspruch 5, dadurch gekennzeichnet, daß die Korrekturöffnungen (z. B. 50b) einer Komplementärmaske (z. B. 41) von den Hauptöffnungen (z. B. 40b) durch schmale Stege (52) getrennt sind.

7. Verfahren zur Messung des Proximity Effekts in Photolacken, insbesondere für Kompensationsverfahren nach einem der Ansprüche 1 bis 6, dadurch gekennzeichnet,
daß im Photolack Muster mit Stegen (62; Fig. 6) belichtet werden, deren Breite (d) von Steg zu Steg abnimmt,
daß der Entwicklungsprozeß vorzeitig abgebrochen wird (ungefähr 60 bis 70% der Entwicklungszeit),
daß die Stegkanten (61, 63) auf geometrische Symmetrie untersucht werden, und
daß jene Stegbreite bestimmt wird, bei der erstmals eine Unsymmetrie der Kanten auftritt, welche Stegbreite ein Maß für den Proximity Effekt ist.

8. Verfahren nach Anspruch 7, dadurch gekennzeichnet, daß die Untersuchung auf Symmetrie mit lichtoptischen Mitteln erfolgt.

## Claims

1. Method of compensating the proximity effect in the imaging of patterns in electron beam projection systems, characterized in that for selected pattern areas at least two common additional electron beam exposures are carried out, the cross-section of an exposure beam being reduced in its dimensions relative to the other one.

2. Method as claimed in claim 1, characterized in that the electron beam exposures are carried out with the same intensity.

3. Method as claimed in claim 1 or 2, characterized in that the individual areas are determined in accordance with their local surroundings decisive for the proximity effect.

4. Method as claimed in any one of claims 1 to 3, characterized in that each selected area is exposed through its own exposure mask with corresponding openings.

5. Method as claimed in any one of claims 1 to 3, characterized in that for exposing a predetermined pattern element two complementary individual masks (41, 42) are used, each complementary mask having additional correction openings (50b, d and 50a, c, resp.) for double exposure of selected areas of the exposure zones (40b, d and 40a, c, resp.) of the other complementary mask.

6. Method as claimed in claim 5, characterized in that the correction openings (e.g. 50b) of a complementary mask (e.g. 41) are separated from the main openings (e.g. 40b) by narrow ridges (52).

7. Method of measuring the proximity effect in photoresists, particularly for compensation methods as claimed in any one of claims 1 to 6, characterized in that in the photoresist patterns with ridges (62; fig. 6) are exposed whose width decreases from one ridge to the other, that the developing process of the photoresist is prematurely discontinued (approximately 60 to 70% of the developing time), that the ridge edges (61, 63) are examined for geometrical symmetry, and that that ridge width is determined which is the first to show an symmetry of the edges, and which is a measure for the proximity effect.

8. Method as claimed in claim 7, characterized in that the symmetry examination is effected with photo-optical means.

## Revendications

1. Procédé de compensation de l'effet de proximité lors de la représentation de motifs dans des dispositifs de projection de faisceau électronique, caractérisé en ce que, pour des zones sélectionnées du motif, on effectue au moins deux expositions par faisceau électronique, la section d'un pinceau d'exposition étant réduite en dimensions par rapport à l'autre.

2. Procédé selon la revendication 1, caractérisé en ce que les expositions par faisceau électronique sont effectuées avec une même intensité.

3. Procédé selon la revendication 1 ou 2, caractérisé en ce que les différentes zones sont sélectionnées en correspondance à l'environnement local, déterminant pour l'effet de proximité.

4. Procédé selon l'une quelconque des revendications 1 à 3, caractérisé en ce que chaque exposition d'une zone sélectionnée est effectuée au travers d'un masque d'exposition associée comportant des ouvertures correspondantes.

5. Procédé selon l'une quelconque des revendications 1 à 3, caractérisé en ce que, pour l'exposition d'un élément déterminé de motif, on utilise deux masques individuels complémentaires (41, 42), chaque masque complémentaire comportant des ouvertures additionnelles de correction (50b, d et 50a, c), pour exposer doublement des régions sélectionnées des zones d'exposition (40b, d et 40a, c) de l'autre masque complémentaire).

6. Procédé selon la revendication 5, caractérisé en ce que les ouvertures de correction (par exemple 50b) d'un masque complémentaire (par exemple 41) sont séparées des ouvertures principales (par exemple 40b) par des ponts étroits (52).

7. Procédé pour mesurer l'effet de proximité dans les photolaques, notamment pour un procédé de compensation selon l'une quelconque des revendications 1 à 6, caractérisé en ce que, dans la photolaque, on assure l'exposition de motifs comportant des ponts (62; fig. 6), dont la largeur (d) diminue d'un pont à un autre, en ce que le processus de développement de la photolaque est interrompue prématurément (approximativement au bout de 60 à 70% du temps de développement), en ce que les bords de ponts (61, 63) sont analysés en ce qui concerne la symétrie géométrique, et en ce qu'on détermine chaque largeur de pont pour laquelle il se produit pour la première fois une asymétrie des bords, cette largeur de pont constituant une mesure de l'effet de proximité.

8. Procédé selon la revendication 7, caractérisé en ce que l'analyse de symétrie est effectuée avec des moyens d'optique lumineux.

FIG. 1B

FIG. 1A

FIG. 3A

FIG. 2

FIG. 3B

FIG. 3C

# FIG. 4A

40a
40
M
40b
40d
40c

# FIG. 4B

40a
41
40c

# FIG. 4C

42
40d
40b

# FIG. 6A

60
65
62
d
66
61
63 64

# FIG. 6B

60
65
62
d'
66
61
63 64

# FIG. 6C

60
65
62
d
66
61
63
64

# FIG. 6D

60
65
62
66
61
63 64

FIG.5 A

FIG.5 B

FIG.5 C

FIG.5 D

FIG.5 E

FIG.7A

FIG.7B

FIG.7C

FIG.7D